# EUROPÄISCHE PATENTANMELDUNG

(11) **EP 2 704 213 A1**
(43) Veröffentlichungstag der Anmeldung: **05.03.2014**
(21) Anmeldenummer: 12182323.1
(22) Anmeldetag: 30.08.2012
(51) Int. Cl.: H01L 31/18, H01L 31/05

(54) **Verfahren und Vorrichtung zum Verbinden von Solarzellen zu einem Solarzellen-String sowie Solarzellen-String**

(71) Anmelder: Komax Holding AG, 6036 Dierikon (CH)
(72) Erfinder: Kaufmann, Stefan, 5000 Aarau (CH); Hofer, Adolf, 8426 Lufingen (CH); Gretler, Andrian, Dallastown, PA 17373 (US)
(74) Vertreter: Blöchle, Hans

(57) **Zusammenfassung**

Eine Vorrichtung zum elektrischen Verbinden von Rückseiten-Solarzellen (2, 2', 2") zu einem Solarzellen-String weist eine Applizier-Einheit zum Aufbringen von doppelseitig klebenden Isolationsbändern (11, 11', 11") auf die hintereinander entlang einer Längsrichtung (x) angeordneten Solarzellen (2, 2', 2") auf, welche durch Anpressen an die Solarzellen befestigt werden. Weiter weist die Vorrichtung eine Bestückungs-Einheit zum Positionieren von elektrischen Leiterelementen (12) zum Verbinden jeweils zweier benachbarter Solarzellen auf die Isolationsbänder (11, 11', 11") auf. Die Leiterelementen (12) sind zum Schaffen von Zugentlastungsstrukturen (26) als Biegeteile ausgebildet, die in einer neben der Applizier-Einheit angeordneten Umformeinheit (8) gefertigt wurden.

## Beschreibung

Die Erfindung betrifft ein Verfahren und eine Vorrichtung zum Verbinden von Solarzellen zu einem Solarzellen-String. Weiter ist die Erfindung auf einen Solarzellen-String gerichtet. Die Erfindung eignet sich insbesondere zum Verbinden von sogenannten Rückseiten-Solarzellen, die sich dadurch auszeichnen, dass sich die Plus- und Minus-Pole auf derselben Seite befinden.

Solarzellen nutzen den Photoeffekt, um aus Strahlungsenergie Strom herstellen zu können. Sie bestehen typischerweise aus Silizium (oder einem anderen Halbleiter) und haben einen pn-Übergang, um die Ladungsträger zu trennen. In konventionellen Solarzellen befindet sich die p-dotierte Zone und die n-dotierte Zone übereinander. Um aneinander gereihte Solarzellen in Serie unter Verwendung von Leitern beispielsweise aus Kupfer zu verschalten ("Verstringen"), muss immer die dem Sonnenlicht zugewandte Seite (kurz "Sonnenseite") der einen Zelle elektrisch mit der Rückseite der nächsten Zelle verbunden werden. Ein Nachteil derartiger Solarzellen-String besteht darin, dass Verschattungen der Sonnenseite durch die elektrischen Leiter (typischerweise beschichtete Kupferbändchen) unvermeidbar sind, was sich negativ auf den Wirkungsgrad auswirkt. Seit einiger Zeit sind Rückseiten-Solarzellen (oder auch Rückseitenkontakt-Solarzellen, v.a. unter der englischen Bezeichnung "Back Contact Cells") bekannt geworden, die sich gegenüber den konventionellen Solarzellen wachsender Beliebtheit erfreuen. Da sich die Pole (+, -) bei Rückseiten-Solarzellen auf der Rückseite (d.h. auf der der Sonnenseite gegenüberliegenden Seite) befinden, ergibt sich verglichen mit konventionellen Solarzellen der Vorteil, dass auf der vorderen, nicht aktiven Seite keine (z.B. bei IBC-Solarzellen, engl. "Interdigitated Back Contact Cells") oder nur noch sehr geringe Abschattungen (z.B. bei MWT-Solarzellen, "Metal Wrap Through" Technologie) auftreten. Dies hat einen grösseren Wirkungsgrad zur Folge. Zudem können die Leiter auf der Rückseite nahezu beliebig gross gemacht werden könnten, ohne dass eine Abschattung erfolgt. Ein Nachteil besteht darin, dass bei der Fertigstellung des Kontakts (beispielsweise mittels Löten) die Rückseiten-Solarzellen - aufgrund des asymentischen Aufbaus (Silizium - Kupfer) - stärker durchbiegen als die konventionell verstringten Zellen. Der Grund für diesen Bimetall-Effekt liegt in den unterschiedlichen Ausdehnungskoeffizienten von Silizium und Kupfer und die für die elektrische Verbindung notwenige Zuführung von Wärme.

Es ist daher die Aufgabe der Erfindung, ein Verfahren und eine Vorrichtung zum Verbinden von Solarzellen zu schaffen, mit welcher Solarzellen-Strings einfach und kostengünstig herstellbar sind. Insbesondere sollen sich das Verfahren und die Vorrichtung zum Verbinden von Rückseiten-Solarzellen eignen. Weiter soll die Vorrichtung sicher betreibbar sein und sich durch eine hohe Produktivität auszeichnen. Die derart hergestellten Solarzellen-Strings sollen dabei infolge thermischer Beanspruchung beispielsweise infolge eines Lötprozesses keine oder nur sehr geringe Durchbiegung erfahren.

Diese Aufgaben werden erfindungsgemäss mit einem Verfahren mit den Merkmalen des Anspruches 1 gelöst. Dieser betrifft ein Verfahren zum Verbinden von hintereinander entlang einer Längsrichtung angeordneten Solarzellen und insbesondere von Rückseiten-solarzellen zu einem Solarzellen-String, wobei das Verfahren folgende Schritte aufweist: Aufbringen wenigstens eines sich wenigstens abschnittsweise in Längsrichtung erstreckenden Isolationsbandes auf die Solarzellen, wobei das aufgebrachte Isolationsband vorzugsweise Freiräume zum Erstellen des elektrischen Kontakts zu den Solarzellen aufweist oder vorgibt; und Positionieren von sich in Längsrichtung erstreckenden elektrischen Leitungen auf das wenigstens eine Isolationsband zum Verbinden jeweils zweier benachbarter Solarzellen, wobei die Leiter über die erwähnten Freiräume mit den Solarzellen verbunden werden können. Das Isolationsband kann durchgehend ausgebildet sein und sich über die gesamte Länge des Solarzellen-Strings erstrecken. Dies hat auch den Vorteil, dass für die oftmals erwünschte Abdeckung der elektrischen Leitungen zwischen den Solarzellen kein zusätzliches Element nötig ist. Alternativ kann das jeweilige Isolationsband auch in Isolationsabschnitte aufgeteilt sein, wobei ein Isolationsabschnitt je einer Solarzelle des Solarzellen-Strings zugeordnet sein kann. Vorteilhaft ist das Isolationsband im Vergleich zur Breite der Solarzelle vergleichsweise schmal ausgeführt, wodurch sich der Materialaufwand erheblich reduzieren lässt. Derartige Isolationsbänder sind günstig und in unterschiedlichen Breiten, Dicken und Zusammensetzungen erhältlich oder einfach herstellbar und an den jeweiligen Einsatzzweck optimal anpassbar.

Das Isolationsband besteht im Wesentlichen aus einem elektrisch nicht oder nur schwach leitfähigen Material und bevorzugt aus einem flexiblen Kunststoffmaterial.

In einer ersten Ausführungsform ist das Isolationsband als doppelseitig klebendes Band ausgestaltet, welches durch Anpressen an die Solarzellen befestigt wird. Die Befestigung erfolgt dabei bevorzugt auf der Rückseite (d. h. die der Sonnenseite abgewandte Seite) der Solarzellen. Ein derartiges Isolationsband lässt sich besonders einfach und in einem einzigen Arbeitsschritt auf die Solarzellen aufbringen. Ein vormaliges Auftragen von Klebstoffen ist ersichtlicherweise nicht nötig. Ein besonderer Vorteil besteht darin, dass die Leiter durch blosses Anpressen an das Isolationsband wenigstens provisorisch und vorzugsweise unlösbar an die mit Isolationsbändern versehenen Solarzellen gewissermassen automatisch und auf sichere Art und Weise befestigt werden können. Es können handelsübliche doppelseitig klebende Bänder mit Isolationseigenschaften verwendet werden, welche beispielsweise in Form von Rollen erhältlich sind, was sich nochmals kostengünstig auswirkt. Das Trägermaterial für diese Bänder kann aus Kunststoff (z.B. PP, PE, PET, PTFE) bestehen, welches auf beiden Seiten beispielsweise mit Acrylatklebstoff beschichtet ist.

Weiter kann es vorteilhaft sein, wenn das wenigstens eine Isolationsband mit Öffnungen oder Löchern zum Schaffen der Freiräume zum Erstellen eines elektrischen Kontakts zu den Solarzellen versehen wird, wobei das Versehen mit den Öffnungen vorzugsweise beim Zuführen des Isolationsbandes zu den Solarzellen erfolgt. Eine solche Ausgestaltung stellt auch sicher, dass einfach und unter Verwendung desselben Ausgangs-Isolationsbandmaterial verschiedene Solarzellengrössen und -typen verarbeitbar sind. Selbstverständlich wäre es aber auch denkbar, vorfabrizierte Isolationsbänder zu verwenden, die bereits Öffnungen aufweisen. Die Freiräume könnten alternativ auch durch Unterbrüche zwischen einzelnen, in Längsrichtung hintereinander angeordneten, kurzen Isolationsbandabschnitten gebildet werden.

Die Leiter können streifenförmige, als Biegeteile zum Schaffen von Zugentlastungsstrukturen ausgebildete Leiterelemente aus gut leitfähigem Metall (z.B. Kupfer) sein. Beispielsweise können Kupferbändern verwendet werden, die verzinnt (mit Lot beschichtet) oder versilbert sind. Es sind aber auch andere Materialien (wie etwa Aluminium) vorstellbar. Diese Zugentlastungsstrukturen verhindern, dass eine unerwünschte, thermisch beeinflusste Durchbiegung der Solarzellen bei einem nachfolgenden Kontaktier-Verfahren mittels z.B. Löten oder Schweissen reduziert wird. Als Entlastungsstrukturen können die Leiter beispielsweise Bögen oder Federn aufweisen, die thermisch bedingte Ausdehnungen ausgleichen. Die erwähnten als Biegeteile ausgebildeten Leiterelemente werden aus vorzugsweise schmalen Metallbändern durch Umformprozesse plastisch verformt. Die Metallbänder und folglich die Leiterelemente können für die gängigen Solarzellen zwischen 0.01 mm und 1 mm dick und 0.5 mm bis zu ca. 50 mm breit sein. Diese bestehen aus Kupferbändern, die in der Regel verzinnt (mit Lot beschichtet) oder in einzelnen Fällen versilbert sind.

Wenn die elektrischen Leiter zum elektrischen Verbinden der Solarzellen streifenförmige Leiterelemente ("Leiterbändchen") sind, kann es vorteilhaft sein, wenn die Leiterelemente vorzugsweise aus einer Metallband-Rolle abgezogen und anschliessend abgelängt und zum Schaffen der Zugentlastungsstrukturen geformt werden. Dabei kann das Ablängen und der Formvorgang unter Verwendung vorzugsweise einer Umformeinheit, enthaltend Biegestempel und Biegegesenk, bevorzugt gleichzeitig erfolgen. Das gleichzeitige Ablängen und Schaffen der Zugentlastungsstrukturen mit Hilfe der Umformeinheit könnte auch ohne die Verwendung des vorerwähnten Isolationsbandes vorteilhaft sein.

Die erfindungsgemässe Vorrichtung zum elektrischen Verbinden von Solarzellen und insbesondere von Rückseiten-Solarzellen zu einem Solarzellen-String weist eine Applizier-Einheit zum Aufbringen wenigstens eines Isolationsbandes auf die hintereinander entlang einer Längsrichtung angeordneten Solarzellen auf, wobei das aufgebrachte Isolationsband vorzugsweise Freiräume zum Erstellen des elektrischen Kontakts zu den Solarzellen aufweist oder vorgibt. Weiter weist die Vorrichtung eine Bestückungseinheit zum Positionieren von elektrischen Leitern zum Verbinden jeweils zweier benachbarter Solarzellen auf das wenigstens eine Isolationsband auf, wobei die Leiter vorzugsweise über die erwähnten Freiräume mit den Solarzellen verbindbar sind.

Wenn das wenigstens eine Isolationsband als doppelseitig klebendes Band ausgestaltet ist, kann es vorteilhaft sein, dass die Applizier-Einheit Mittel zum Anpressen des Isolationsbandes auf die Solarzellen aufweist. Das Anpress-Mittel kann ein relativ fest stehendes Bauteil mit einer Gleitfläche sein, an der das Isolationsband entlang fahrbar ist und die wenigstens bereichsweise die Rückseite der Solarzellen mit einer beispielsweise mittels Mitteln zum Erwirken einer Vorspannkraft pressend beaufschlägt. Selbstverständlich könnten die Anpressmittel auch anders ausgeführt sein. Vorstellbar wäre beispielsweise die Verwendung einer frei drehbaren, auf der Solarzellen-Rückseite abrollbaren UmlenkRolle für das Isolationsband.

Die Vorrichtung kann eine Lochstation zum Versehen der Öffnungen in das Isolationsband aufweisen. Die Lochstation kann dabei vorteilhaft zwischen einer quer zur Längsrichtung und bevorzugt frei drehbar gelagerten Isolationsband-Rolle und der Applizier-Einheit angeordnet sein. Die Lochstation kann Mittel zum Stanzen oder Schneiden von Öffnungen aus dem Isolationsband aufweisen.

Die Solarzellen können zwei oder drei nebeneinander angeordnete Reihen von Kontaktzonen aufweisen, die etwa parallel zueinander in Längsrichtung ausgerichtet sind. Jeder Kontaktzonen-Reihe kann dabei ein Plus- und Minuspol zugeordnet sein. In diesem Fall kann es vorteilhaft sein, wenn die Vorrichtung je Kontaktzonen-Reihe jeweils eine Applizier-Einheit und gegebenenfalls eine Lochstation aufweist, wobei die Applizier-Einheiten in einer Reihe nebeneinander oder in Bezug auf die Längsrichtung versetzt zueinander angeordnet sein können. Besonders vorteilhaft kann es sein, wenn die Applizier-Einheiten derart versetzt zueinander angeordnet sind, dass die jeweiligen Applizier-Einheiten je einer von drei hintereinander angeordneten Solarzellen zugeordnet sind.

In einer weiteren Ausführungsform kann die Vorrichtung wenigstens eine Vorratsrolle oder -spule zum Bevorraten von Material zum Herstellen der Leiter aufweisen, von der mittels einer Abzieh-Einheit Leitermaterial abziehbar ist.

Die Abzieh-Einheit kann wenigstens einen Greifer zum klemmenden Ergreifen des freien Endes des Leitermaterials von der Vorratsrolle aufweisen.

Weiter kann es vorteilhaft sein, wenn die Vorrichtung eine Umformeinheit zum Schaffen von Zugentlastungsstrukturen für die Leiterelemente aufweist. Mit der Umformeinheit können auch bevorzugt auf einer gemeinsamen Ebene liegende, plane Befestigungsabschnitte und Kontaktabschnitte für die Leiterelemente auf einfache Art und Weise gefertigt werden. Die Leiterelemente können aus einem schmalen Kupferband gefertigt werden. Eine derartige Umformeinheit könnte auch in anderen Vorrichtungen zum Verbinden von Solarzellen eingesetzt werden. Eine solche Vorrichting könnte beispielsweise eine Applizier-Einheit zum Beschichten der Solarzellen mit einem Isolationsmaterial (aufweisen. Diese Umformeinheit könnte sogar auch für konventionelle Stringer, bei denen jeweils eine Sonnenseite mit einer Rückseite verbunden werden, vorteilhaft sein. In diesem Fall würde die Vorrichtung zum elektrischen Verbinden von Solarzellen eine Bestückungs-Einheit zum Positionieren von elektrischen Leitern zum Verbinden jeweils zweier benachbarter Solarzellen auf die Solarzellen und eine Umformeinheit zum Schaffen von Zugentlastungsstrukturen für die Leiterelemente umfassen.

Die Umformeinheit kann ein Biegegesenk und einen Biegestempel enthalten, wobei wenigstens das Biegegesenk zweiteilig ausgebildet ist und wobei die beiden Biegegesenkteile zum Einstellen der Länge der Leiterelemente in Längsrichtung relativ zueinander verschiebbar sind. Mit einer derartigen Anordnung ist ein effizienter Betrieb und breites Einsatzgebiet gewährleistet, ein Auswechseln des Umform-Werkzeuges zum Umrüsten auf unterschiedliche Solarzellen-Grössen ist nicht nötig.

Weiter kann es vorteilhaft sein, wenn die Umformeinheit ein Biegegesenk und einen Biegestempel enthält, wobei das Biegegesenk und der Biegestempel jeweils zweiteilig ausgebildet sind. Die Biegegesenkteile und die zugehörigen Stempelteile können paarweise zum Bilden einer Verformung der Leiterelemente in Querrichtung rechtwinklig zur Längsrichtung relativ zueinander verschiebbar sein. Dies kann von Nutzen sein, um ein allfälliges Drehen der Solarzellen bezüglich der Ausrichtung der Kontaktzonen-Reihen mit gleicher Polarisierung zu vermeiden.

Die Umformeinheit kann Bestandteil einer Stanzstation sein, mit der neben dem Umformvorgang die Leiterelemente auf die gewünschte Länge ablängbar sind. Die Abläng-Mittel können dabei durch entsprechende Formgebungen im Biegegesenk oder im Biegestempel integriert sein. Selbstverständlich könnte die Stanzstation auch eine separat zur Umformeinheit verfahrbare Schneide zum Ablängen der Leiterelemente aufweisen.

Weiter kann die Vorrichtung eine Förderrichtung zum Fördern der hintereinander angeordneten Solarzellen in Längsrichtung aufweisen. Dabei kann die Applizier-Einheit derartig über oder unter der Fördereinrichtung angeordnet sein, dass das wenigstens eine Isolationsband beim Fördervorgang auf die Solarzellen aufgebracht wird.

Die Umformeinheit und gegebenenfalls die Stanz-Station können in Bezug auf die Längsrichtung neben der Fördereinrichtung angeordnet sein. Die Leiterelemente können mittels einer beispielsweise nach einem Pick and Place-Verfahren arbeitenden Bestückungs-Einheit von der Stanz-Station entnommen und auf das wenigstens eine Isolationsband abgelegt werden.

Ein weiterer Aspekt der Erfindung betrifft einen Solarzellen-String, der vorzugsweise nach dem vorgängig beschrieben Verfahren und/oder unter Verwendung der vorgängig beschriebenen Vorrichtung hergestellt wurde. Der Solarzellen-String weist hintereinander entlang einer Längsrichtung angeordnete Solarzellen auf. Bevorzugt handelt es sich dabei um Rückseiten-Solarzellen. Der Solarzellen-String weist wenigstens ein auf den Solarzellen angeordneten, sich in Längsrichtung erstreckendes Isolationsband und auf dem Isolationsband befestigte, sich in Längsrichtung erstreckende elektrische Leiter auf, die jeweils zwei benachbarte Solarzellen elektrisch miteinander verbinden. Das Isolationsband kann Öffnungen oder andere Freiräume aufweisen, über die der elektrische Leiter mit je einer Kontaktstelle auf den Rückseiten der Solarzellen zum Erstellen eines elektrischen Kontakts anliegt. Das Isolierband kann kontinuierlich über sämtliche Zellen eines Strings gehen und damit die elektrischen Leiter abdecken, so dass diese im fertigen Solar-Modul nicht sichtbar sind.

Die Leiter können jeweils streifenförmige Leiterelemente sein, die zum Schaffen von Zugentlastungsstrukturen als Biegeteile aus Metall ausgebildet sind. Die Leiterelemente können jeweils wenigstens einen flächig auf dem Isolationsband aufliegenden Befestigungsabschnitt sowie gegebenenfalls flächig auf den Solarzellen im Bereich der Kontaktstellen aufliegenden Kontaktabschnitte aufweisen.

Weitere Einzelmerkmale und Vorteile der Erfindung ergeben sich aus der nachfolgenden Beschreibung von Ausführungsbeispielen und aus den Zeichnungen. Es zeigen:
- Fig. 1: eine perspektivische Darstellung einer erfindungsgemässen Vorrichtung zum Verbinden von Solarzellen zu einem Solarzellen-String,
- Fig. 2: eine Applizier-Station mit Applizier-Einheiten zum Aufbringen von Isolationsbändern auf die Solarzellen in einer vergrösserten Darstellung (Detail A aus Fig. 1),
- Fig. 2a: eine Applizier-Einheit gemäss einem alternativen Ausführungsbeispiel zu Fig. 2,
- Fig. 3: eine Stanz-Station mit einer Umform-Einheit und Abzieh-Einheiten zum Herstellen von auf die Solarzellen aufzubringenden Leiter-Elementen (Detail B aus Fig. 1),
- Fig. 4: eine Bestückungs-Einheit zum Positionieren der Leiter-Elemente auf die Isolationsbänder und eine Löt-Station (Detail C aus Fig. 1),
- Fig. 5A: die Stanz-Station mit einer offenen Umform-Einheit und einer Auszieh-Einheit in einer Ausgangsstellung,
- Fig. 5B: die Stanz-Station mit ausgezogenem Material zum Herstellen der Leiterelemente,
- Fig. 5C: die Stanz-Station in Schliessstellung,
- Fig. 6A: die Stanz-Station aus Fig. 5A, jedoch mit auseinandergezogenen Biegegesenkteilen der Umform-Einheit,
- Fig. 6b: die Stanz-Station nach Ausziehen des Leitermaterials für die Leiterelemente,
- Fig. 6c: die Stanzstation in der Schliessstellung,
- Fig. 7: eine geschlossene Umform-Einheit in einer weiteren Arbeits-Stellung,
- Fig. 8: die Umform-Einheit aus Fig. 7 mit entferntem vorderen Stempelteil,
- Fig. 9: eine stark vergrösserte Detaildarstellung der Umform-Einheit aus Fig. 8,
- Fig. 10: einen Ausschnitt eines mit der erfindungsgemässen Vorrichtung hergestellten Solarzellen-Strings in einer vergrösserten Darstellung,
- Fig. 11: einen alternativen Solarzellen-String, und
- Figur 12: einen weiteren Solarzellen-String.

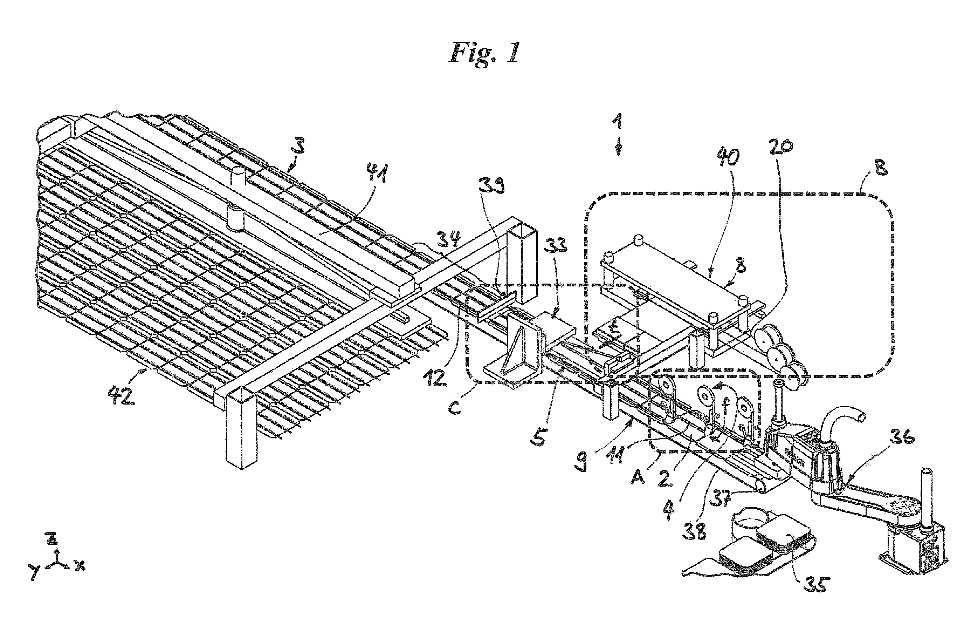

Figur 1 zeigt eine insgesamt mit "1" bezeichnete Vorrichtung zum elektrischen Verbinden von Solarzellen 2 zu einem Solarzellen-String 3. Die Vorrichtung 1 verfügt über eine Fördereinrichtung 9 mit der hintereinander angeordnete Solarzellen 2 in die mit dem Pfeil x angedeutete Längsrichtung an oder durch die Vorrichtung 1 in f-Richtung gefördert werden. Die Fördereinrichtung 9 ist vorliegend als mit einem Vakuumband ausgerüsteten Bandförderer ausgestaltet. In Fig. 1 ist das Förderband 38 und im vorderen Bereich eine Umlenkrolle 37 des Bandförderers erkennbar. Selbstverständlich wären aber auch andere Fördermittel wie etwa ein Hubbalken ("Walking Beam") vorstellbar. Mittels eines Schwenkarme aufweisenden Roboters 36 werden einzelne Solarzellen von einem Solarzellen-Stapel 35 aufgenommen und am Bandanfang der Fördereinrichtung 9 abgelegt. Der Roboter 36 ist ebenfalls in der Lage, bei Bedarf die Solarzellen um 180° zu drehen und so die Orientierung zu ändern. Die Solarzellen 2 passieren dann zunächst eine Applizier-Station, die drei Applizier-Einheiten 4 aufweist. Mit den Applizier-Einheiten 4 werden Isolationsbänder 11 auf die Solarzellen 2 aufgebracht. Nach Passieren dieser Applizier-Station weisen die Solarzellen parallel in x-Richtung bzw. Längsrichtung verlaufende Isolationsbänder 11 auf. Anstatt der drei jeweils parallel verlaufenden Isolationsbändern könnten selbstverständlich auch lediglich zwei oder sogar bloss ein Isolationsband auf die Solarzellen aufgebracht werden.

Mit der hier gezeigten Vorrichtung werden Rückseiten-Solarzellen verarbeitet. Die Solarzellen werden dabei im Ausführungsbeispiel gemäss Fig. 1 derart auf das Förderband 38 platziert, dass die Rückseiten (d.h. die der Sonnenseite bzw. aktiven Seite abgewandten Seite) oben sind und frei liegen.

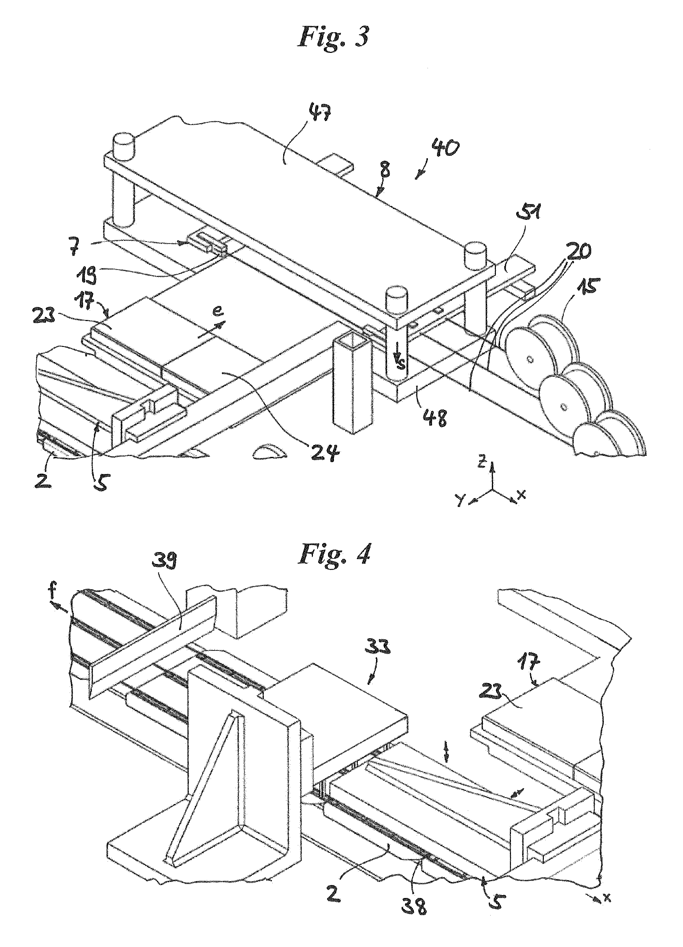

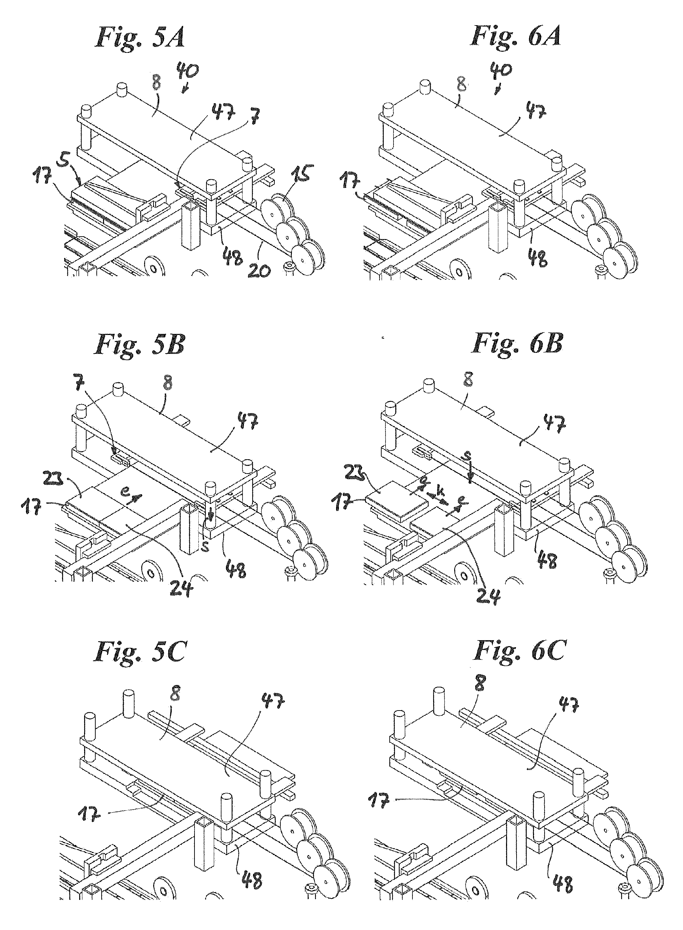

Die Vorrichtung 1 umfasst weiter eine mit "40" bezeichnete Stanz-Station, die neben der Fördereinrichtung 9 angeordnet ist. In der Stanz-Station 40 wird beispielsweise streifenförmiges Kupfer (z.B. verzinnte Kupferbänder) enthaltendes Leitermaterial zu Leiterelementen verarbeitet. Die Kupferbänder sind zwischen 0.01 mm und 1 mm dick und weisen eine Breite von 0.5 mm bis zu 50 mm auf. Details zur Ausgestaltung der Stanzstation sind aus nachfolgender Fig. 3 sowie aus den Figuren 5 und 6 entnehmbar. Die fertigen Leiterelemente aus Kupfer werden dann mit Hilfe einer Bestückungseinheit 5 von der Stanz-Station 40 zu den Solarzellen 2 transferiert und jeweils im Bereich der Isolationsbänder 11 auf die Solarzellen positioniert. Die nun mit Leiterelementen bestückten Solarzellen passieren schliesslich eine Lötstation 33 mit einer Vorheizzone, ein nachgelagerter Kühlbereich ist mit 34 angedeutet. Anstatt von in der Station 33 durchgeführten Lötprozessen (mit Heissluft, Induktion oder durch Berührung) kommen auch andere Kontaktierungs- oder Verbindungsverfahren zum Fertigstellen der elektrischen Verbindung zwischen Leiter und Solarzelle wie etwa; Laserschweissen, Ultraschall-Schweissen oder Kleben in Frage. Mit einer Trennschneide 39 wird der so hergestellte Solarzellen-String in der gewünschten Länge abgetrennt. Ein fertiggestellter Solarzellen-String ist mit 3 bezeichnet. Solarzellen-Strings 3 können dann mit einer Transfereinrichtung 41 in der Lay-Up Station zum Bilden eines Solar-Modules zu einer Matrix 42 zusammengesetzt werden.

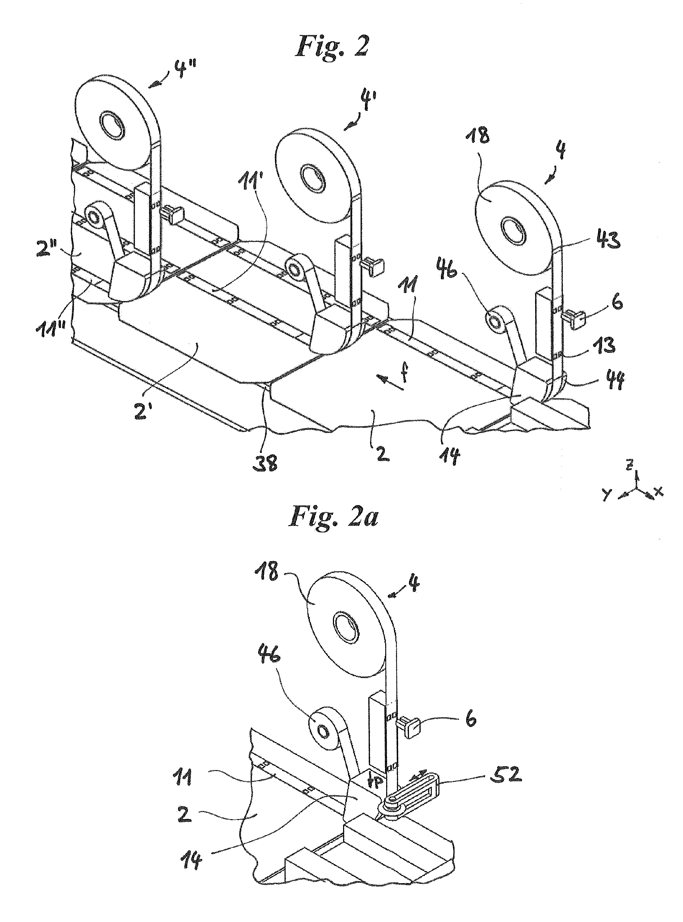

Aus Figur 2 sind Details der Applizier-Station erkennbar, mit der Isolationsbänder auf die Solarzellen 2 aufgebracht werden. Die Applizier-Station verfügt über drei Applizier-Einheiten, wobei eine erste Applizier-Einheit mit 4 und die nachfolgenden mit 4' und 4" bezeichnet wurden. Ersichtlicherweise sind im vorliegenden Ausführungsbeispiel die einzelnen Applizier-Einheiten 4, 4' und 4" versetzt zueinander angeordnet. Selbstverständlich wären auch andere Anordnungen, beispielsweise könnten die Applizier-Einheiten nebeneinander in derselben Position in Bezug auf die Längsrichtung angeordnet sein. Jede Applizier-Einheit enthält eine Vorratsrolle 18, von der Isolationsband entnommen und auf die Solarzellen aufgebracht werden kann. Im hier dargestellten Ausführungsbeispiel ist das Isolationsband auf der Vorratsrolle 18 bereits in einzelne, den Abmessungen der Solarzellen entsprechende Isolationsbandabschnitte 11 aufgeteilt. Die Trennstellen zwischen den einzelnen Isolationsbändern bzw. Isolationsbandabschnitten 11 sind mit 43 bezeichnet. Beim Zuführen des Isolationsbandes von der Vorratsrolle 18 zu den Solarzellen 2 werden beispielhaft zwei nebeneinander angeordnete Öffnungen 11 mittels einer Lochstation 6 durch Stanzen in das Isolationsband eingebracht. Die Öffnungen 13 ergeben Freiräume, über die die (hier nicht dargestellten) elektrischen Leiter mit den positiven und negativen Kontaktstellen der Ruckseiten der Solarzellen elektrisch verbunden werden. Das Einbringen der Öffnungen 11 könnte selbstverständlich auch auf anderer Weise, zum Beispiel mittels Laserschneiden erfolgen. Vorstellbar wäre weiter, Positionsmarkierungen auf die Isolationsbänder einzubringen.

Die in einzelne Abschnitte aufgeteilten Isolationsbänder 11 sind als doppelseitiges Klebeband ausgestaltet, das einfach durch blosses Anpressen auf die Solarzellen fixiert werden kann. Die Isolationsbänder 11 bestehen beispielsweise aus einem isolierenden Kunststoff (z.B. PP, PE, PET, PTFE), welcher auf beiden Seiten beispielhaft mit Acrylatklebstoff beschichtet ist. Das Isolationsband wird entlang einer Gleitfläche 44 eines Anpresselements 14 geführt und umgelenkt. Die mit einem Pfeil P angedeutete Anpresskraft erfolgt beispielhaft über ein (nicht dargestelltes) federbewehrtes Element, das das Anpressteil 14 nach unten drückt. In einem Ausgangszustand ist das beidseitig mit Klebstoff beschichtete, auf der der Vorratsrolle 18 aufgewickelte Isolationsband durch einen Trägersteifen (engl. Liner) geschützt. Mit 46 sind Rollen bezeichnet, mit denen die vom Isolationsband entfernten Trägersteifen aufgewickelt werden.

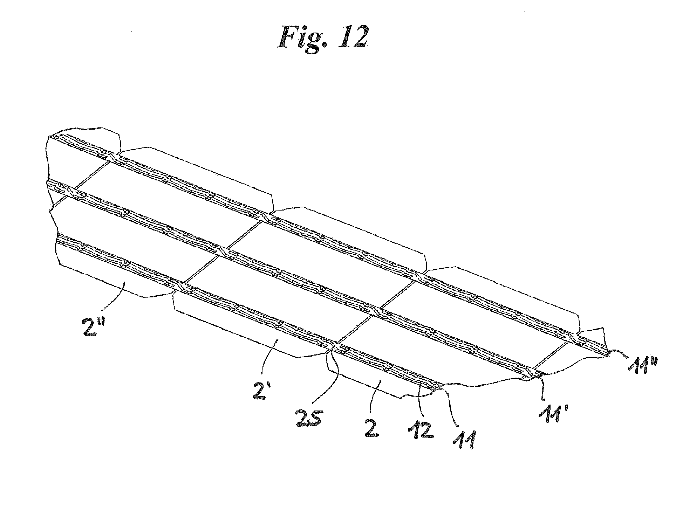

Das auf die Vorratsrolle aufgewickelte Isolationsbandmaterial muss nicht notwendigerweise vorkonfektioniert sein und bereits Trennstellen aufweisen. Das Isolationsbandmaterial kann beispielsweise beim Zuführvorgang in einzelne Bandabschnitte eingeteilt werden. Eine entsprechende konstruktive Lösung zeigt Figur 2a. Mittels einer Schneideinrichtung mit einem hin und her und quer zur Bandlaufrichtung verfahrbaren Rollmesser kann das Bandmaterial durchtrennt werden. Es kann aber auch vorteilhaft sein, das Isolationsbandmaterial nicht in einzelne Abschnitte aufzuteilen und als durchgehendes Band zu belassen (vgl. Fig. 12).

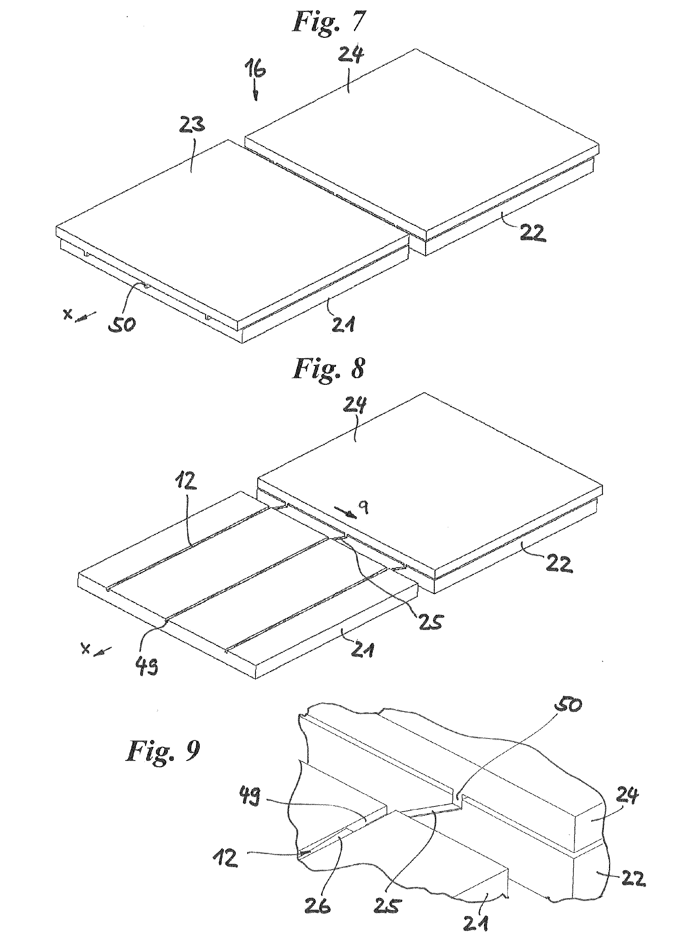

Figur 3 zeigt die Stanz-Station 40. Diese umfasst im Wesentlichen eine Umform-Einheit 8 enthaltend ein zweiteiliges Biegegesenk 17 und einen in z-Richtung auf und ab bewegbaren Biegestempel. Der Biegestempel ist zumindest in den Figuren 1, 3 sowie 5 und 6 nicht erkennbar, da er von einer oberen Platte 47 abgedeckt ist. Diese Platte 47 dient als Abstützung des Biegestempels gegen oben hin (vgl. auch Fig. 7). Als Auflager für das Biegegesenk 17 dient die untere Platte 48. Die Leiterelemente werden aus einem schmalen, wenige Millimeter breiten streifenförmigen Material und bevorzugt aus Kupfer hergestellt. Das von einer Rolle 15 oder Spule stammende Leitermaterial 20 wird mittels Greifern 19 einer Auszieh-Einheit 7 erfasst und zwischen Biegegesenk 17 und Biegestempel 16 durch eine Auszugsbewegung positioniert. Dann wird der Biegestempel, in der mit dem Pfeil "s" angedeuteten Schliessrichtung gegen das Biegegesenk 17 bewegt, wodurch aus dem Leitermaterial ein Zugentlastungsstrukturen aufweisendes, als Biegeteil ausgestaltetes Leiterelement entsteht. Für den Umform-Prozess müsste das Biegegesenk 17 allerdings noch in e-Richtung unter den Biegestempel 16 gefahren werden. Im Weiteren müssen die Leiterelemente auf die richtige Länge zugeschnitten werden. Die Metallbänder werden zwischen der Auszieh-Einheit 7 und Greifern umfassenden Halte- und Trenneinrichtung 51 festgehalten und abgelängt. Alternativ könnte die Stanz-Station 40 zum Ablängen auch ein biegegesenkseitiges Schneidelement verfügen Das Biegegesenk 17 ist quer zur Längsrichtung verschiebbar in der Vorrichtung 1 angeordnet. In der Darstellung gemäss Fig. 3 befindet sich das Biegegesenk in einer gegenüber dem Biegestempel verschobenen Position neben dem Biegestempel 16. In dieser Position können die fertig geformten (nicht dargestellten) Leiterelemente von der Bestückungs-Einheit 5 aufgenommen und zum Befestigen an die Solarzellen transportiert werden.

Die zweiteilige Ausgestaltung der Umform-Einheit 17 ermöglicht die Herstellung von unterschiedlich langen Leiterelementen, ohne dass unbedingt Teile des Leitermaterials weggeschnitten werden müssen. Zu beachten ist, dass die ersten und die letzten Leiterelemente eines Solarzellen-Strings in der Regel kürzer als die Bändchen dazwischen sind, da letztere jeweils zwei Solarzellen miteinander verbinden. Das Anfangs- und das End-Leiterelement werden vorzugsweise jeweils gleichzeitig hergestellt. Dazu müsste hierfür mit dem Biegegesenk ein Versatz (vgl. nachfolgende Fig. 6A) in Längsrichtung gefahren werden.

Aus Figur 4 geht unter anderem hervor, dass sich die Bestückungs-Einheit 5 in Längsrichtung x bzw. in Förderrichtung f über jeweils zwei Solarzellen 2 erstreckt. Dasselbe gilt im Wesentlichen für die Umformeinheit 17. Die Bestückungs-Einheit 5 ist auf und ab und in Querrichtung hin und her bewegbar. Die jeweiligen Bewegungsrichtungen sind in Fig. 4 mittels Doppelpfeilen angedeutet. Mit der Bestückungs-Einheit 5 wird das fertige Leiterelement der Stanz-Station 40 entnommen, quer zur Förderrichtung zu den Solarzellen transferiert und dann durch blosses Andrücken auf das doppelseitig klebende und mit Öffnungen versehene Isolierband geklebt. Die Bestückungs-Einheit 5 ist beispielsweise mit Vakuumsaugern zum Erfassen ("Pick") der Leiterelement ausgerüstetet. Weiter sind in Fig. 4 die Löt-Station 33 und Trenn-Station mit der Schneide 39 erkennbar. Unter Umständen könnte der Löt-Station 33 auch eine Vorheizstation vorgelagert sein, in der die Solarzellenelle von unten und teilweise auch die Leiter vorgewärmt werden.

Die Figuren 5a bis 5c zeigen die einzelnen Sequenzen der Herstellung der Leiterelemente unter Verwendung der Stanzstation 40. In der in Figur 5a gezeigten Ausgangsstellung werden die freien Enden des Leitermaterials 20 von Greifern 19 der Auszieheinheit 7 erfasst und danach in Längsrichtung ausgezogen. Die Ausziehbewegung ist mit einem Pfeil "f" angedeutet. Da die Leiterelemente zwei Solarzellen miteinander verbinden sollen, muss das Leitermaterial soweit ausgezogen werden, dass Leiterelemente der Länge von zwei Solarzellen zuzüglich eines eventuellen Abstands zwischen den Solarzellen herstellbar sind. Danach befindet sich die Auszieh-Einheit 7 in der in Figur 5b gezeigten Stellung. Das Biegegesenk 17 wird danach in e-Richtung in eine Umform-Position unter den Biegestempel gebracht, worauf für den eigentlichen Umformvorgang der Biegestempel 16 gegen das Biegegesenk 17 bewegt wird. Die Schliessrichtung ist dabei mit dem Pfeil "s" angedeutet. Figur 5c zeigt die Stanz-Station 40 mit der Umform-Einheit 7 in einer Schliessstellung. Mittels biegegesenkseitigem Schneidelement 51 werden gleichzeitig mit dem Umformprozess die Leiterelemente durch Abtrennen des Leitermaterials abgelängt.

Die Figuren 6a bis 6c zeigen einen leicht abgewandelten Prozess zum Herstellen eines Leiterelements. Wie aus Figur 6b hervorgeht, sind die beiden Biegegesenkteile relativ zueinander bewegbar und können voneinander in Längsrichtung bewegt werden. Mit dem Doppelpfeil "k" wird diese Funktionalität angedeutet. Durch Bewegen eines der Stempel-Gesenk-Paare 21, 23 oder 22, 24 oder durch ein simultanes Bewegen der Stempel-Gesenk-Paare 21 und 23 bzw. 22 und 24 werden diese voneinander entfernt. Auf diese Weise lässt sich die Länge der Leiterelemente variieren.

Aus Figur 7 geht nochmals deutlich hervor, dass sowohl das Biegegesenk 17 als auch der Biegestempel 16 jeweils zweiteilig ausgestaltet sind. Das Biegegesenk besteht dementsprechend aus den beiden Biegegesenkteilen 21 und 22, der Biegestempel 16 aus den beiden Stempelteilen 23 und 24. Die Biegegesenkteilen 21 und 22 verfügen jeweils über Nuten 49, in die das Leitermaterial aufnehmbar ist. Der Nutboden der Nut 49 ist dabei zum Bilden der Zugentlastungsstrukturen vorgeformt. Die Stempelteile 23 und 24 verfügen über komplementär zu der Nut 49 ausgebildete Vorsprünge 50, die an den Stempelteilen einstückig angeformt sind. Durch eine mit dem Pfeil "q" angedeutete Querbewegung kann das Biegegesenkteil-Stempelteil-Paar 22, 24 derart versetzt werden, dass eine Verformung 25 entsteht. Das zu verformende Leitermaterial ist in den Nuten 49 des Biegegesenks geführt und fixiert um einem möglichen Knicken entgegen zu wirken. Diese Verformung 25 ermöglicht eine Verbindung der Pluskontakte einer Solarzelle mit den Minuskontakten einer nächsten Solarzelle, ohne dass jede zweite Solarzelle um 180° gedreht werden muss. Dies kann insbesondere dann von Vorteil sein, wenn die Anzahl Pluskontakte in einer Reihe parallel zu den Leiterelementen nicht gleich der Anzahl Minuskontakte in einer Reihe parallel zu den Leiterelementen wäre.

Die vorgängig beschriebene Vorrichtung ermöglicht auch ein kontinuierliches Verbinden ("Stringen") von Rückseiten-Solarzellen, wobei jeweils ein String mit dem Pluspol in der einen Richtung und dem Minuspol in der anderen Richtung gebildet werden kann. Der nächste String würde dann so hergestellt werden, dass seine Polarität gerade umgekehrt ist. Dies entspricht gerade der Anordnung in einem Solarmodul und ermöglicht beim Lay-Up einen höheren Durchsatz, da der String für das Lay-Up nicht mehr gedreht werden muss, sondern nur noch verschoben werden muss. Um diese positive Eigenschaft hervorzurufen, muss die erste Zelle des neuen Strings gleich aufgebracht werden wie die letzte Solarzelle des vorherigen Strings. Die Polarität kann durch Drehen der Solarzellen mittels des Roboters 35 um 180° bestimmt werden (Fig. 1).

Die beschriebenen und in den Figuren gezeigten Fertigungs-Stationen und -Einheiten der Vorrichtung könnten auch örtlich getrennt voneinander sein, um die einzelnen Prozesse parallel auszuführen und so den höchstmöglichen Durchsatz zu generieren.

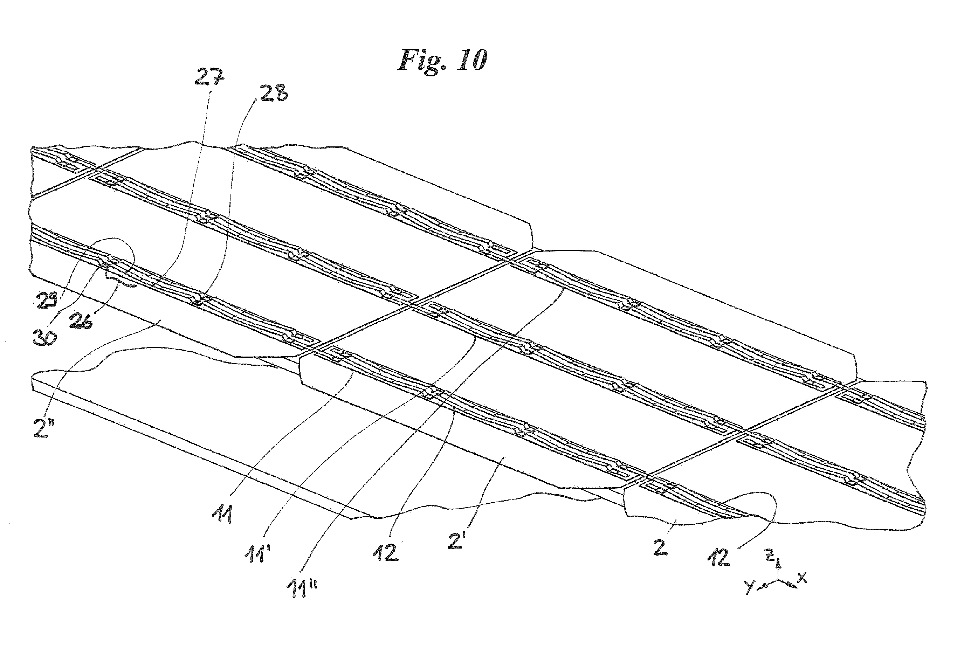

Figur 10 zeigt einen Ausschnitt auf einen Solarzellen-String mit elektrisch über die Leiterelemente 12 verbundenen Solarzellen 2, die sich jeweils über zwei Solarzellen erstreckenden Leiterelemente 12 weisen mehrere (hier: sechs) plane Befestigungsabschnitte 27 auf, die flächig an den Isolationsbändern 11 aufliegen und an diesen fixiert sind. Dadurch ist sichergestellt, dass die Leiterelemente präzise auf das doppelseitig klebende und isolierende Band 11 geklebt werden können. Weiterhin weisen die Leiterelemente 12 als Bogen ausgebildete Zugentlastungsstrukturen 26 auf, die jeweils aus einem ersten Bogenabschnitt 29 und einem vergleichsweise kurzen Bogenabschnitt 30 zusammengesetzt sind. Je Längsreihe sind je Solarzelle vier Kontaktstellen vorgesehen. Die Anordnung der Zugentlastungen und der Befestigungsabschnitte kann auch anders gestaltet werden. Die Isolationsbänder 11 weisen zu den Kontaktzonen korrespondierende Öffnungen 13 auf, über welche die jeweiligen Leiterelemente 12 die Kontaktstellen der Solarzellen 2 direkt kontaktieren. Für eine gute elektrische Verbindung weisen die Leiterelemente flächige Kontaktabschnitte 28 auf. Die vorliegende Leiterelement-Anordnung kann erreicht werden, wenn jede zweite Solarzelle der hintereinander angeordneten Solarzellen 2, 2', 2" um 180 Grad gedreht ist.

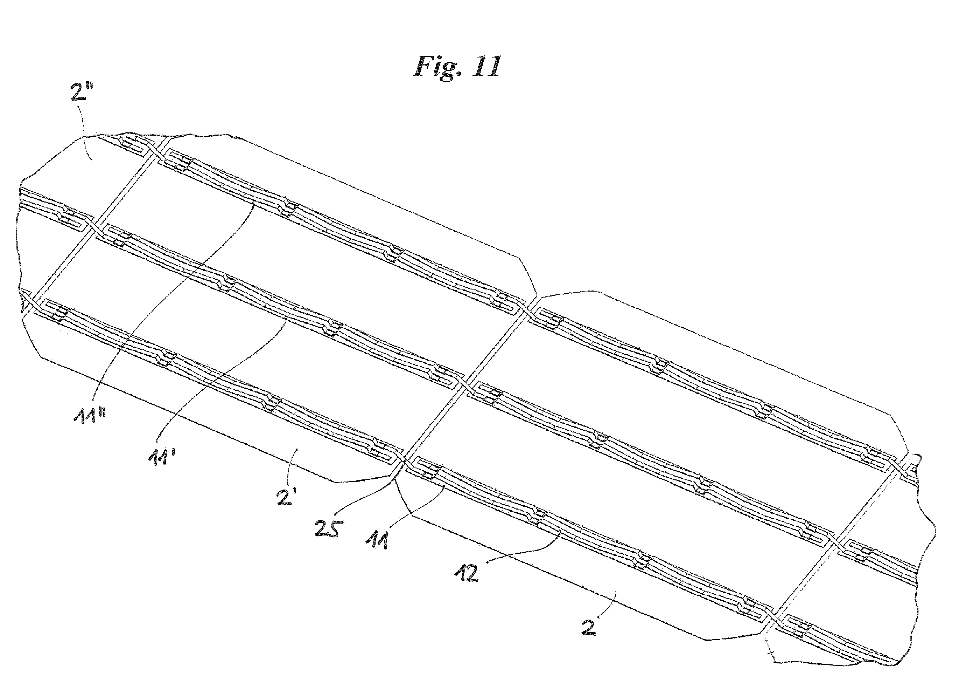

Selbstverständlich lässt sich mit der Vorrichtung auch ein Solarzellen-String anfertigen, bei dem die hintereinander angeordneten bzw. aneinander gereihten Solarzellen gleich orientiert sind. Figur 11 zeigt einen Ausschnitt eines solchen Solarzellen-Strings mit Leiterelementen 12, die jeweils mittig eine schräg in Querrichtung verlaufende Verformung 25 aufweisen, die nach dem Verfahren gemäss den Figuren 7 bis 9 hergestellt wurden.

Der in Figur 12 gezeigte Solarzellen-String weist eine gleichartige Leiteranordnung wie der im Ausführungsbeispiel gemäss Figur 11 gezeigte String auf und unterscheidet sich lediglich dadurch, dass über alle Solarzellen sich erstreckende Isolationsbänder verwendet wurden. Ein Vorteil sich über den gesamte String erstreckenden, durchgehenden Isolationsbändern besteht darin, dass die Leiterelemente im Freiraum zwischen den Solarzellen abgedeckt und so geschützt sind.

## Patentansprüche

1. Verfahren zum Verbinden von hintereinander entlang einer Längsrichtung (x) angeordneten Solarzellen (2, 2', 2") und insbesondere von Rückseiten-Solarzellen zu einem Solarzellen-String (3), enthaltend folgende Schritte:
- Aufbringen wenigstens eines in Längsrichtung erstreckenden Isolationsbands (11, 11', 11") auf die Solarzellen (2, 2', 2"), und
- Positionieren und Fixieren von sich in Längsrichtung erstreckenden elektrischen Leitern (12) auf das wenigstens eine Isolationsband (11, 11', 11") zum Verbinden jeweils zweier benachbarter Solarzellen.

2. Verfahren nach Anspruch 1, **dadurch gekennzeichnet, dass** das Isolationsband (11, 11', 11") als doppelseitig klebendes Band ausgestaltet ist, welches durch Anpressen an die Solarzellen (2, 2', 2")befestigt wird.

3. Verfahren nach Anspruch 1 oder 2, **dadurch gekennzeichnet, dass** das Isolationsband (11, 11', 11") mit Öffnungen (13) zum Schaffen der Freiräume zum Erstellen eines elektrischen Kontakts zu den Solarzellen versehen wird, wobei das Versehen mit den Öffnungen vorzugsweise beim Zuführen des Isolationsbands (11, 11', 11") zu den Solarzellen (2, 2', 2") erfolgt.

4. Verfahren nach einem der Ansprüche 1 bis 3, **dadurch gekennzeichnet, dass** die Leiter streifenförmige, als Biegeteile zum Schaffen von Zugentlastungsstrukturen (26) ausgebildete Leiterelemente (12) aus Metall sind, die aus Leitermaterial in Form von Metallbändern durch Umformprozesse zu Biegeteilen plastisch verformt werden.

5. Verfahren zum elektrischen Verbinden von Solarzellen (2, 2', 2") insbesondere nach Anspruch 4, **dadurch gekennzeichnet, dass** die elektrischen Leiter zum elektrischen Verbinden der Solarzellen streifenförmige Leiterelemente (12) sind, wobei die Leiterelemente (12) vorzugsweise aus einer Metallband-Rolle (15) abgezogen und anschliessend abgelängt und zum Schaffen der Zugentlastungsstrukturen (26) geformt werden, wobei das Ablängen und der Formvorgang unter Verwendung vorzugsweise einer Umformeinheit (8) enthaltend Biegestempel (16) und Biegegesenk (17) bevorzugt gleichzeitig erfolgt.

6. Vorrichtung zum elektrischen Verbinden von Solarzellen (2, 2', 2") und insbesondere von Rückseiten(kontakt)-Solarzellen zu einem Solarzellen-String (3), insbesondere zum Durchführen des Verfahrens gemäss einem der Ansprüche 1 bis 5, enthaltend
- eine Applizier-Einheit (4) zum Aufbringen wenigstens eines Isolationsbands (11, 11', 11") auf die hintereinander entlang einer Längsrichtung (x) angeordneten Solarzellen (2, 2', 2"), und
- eine Bestückungs-Einheit (5) zum Positionieren von elektrischen Leitern (12) zum Verbinden jeweils zweier benachbarter Solarzellen auf das wenigstens eine Isolationsband (11, 11', 11").

7. Vorrichtung nach Anspruch 6, **dadurch gekennzeichnet, dass** das wenigstens eine Isolationsband (11, 11', 11") als doppelseitig klebendes Band ausgestaltet ist und dass die Applizier-Einheit (4) Mittel zum Anpressen des Isolationsbands (11, 11', 11") auf die Solarzellen (2, 2', 2") aufweist.

8. Vorrichtung nach Anspruch 7, **dadurch gekennzeichnet, dass** die Vorrichtung (1) eine Lochstation (6) zum Versehen von Öffnungen (13) in das Isolationsbands (11, 11', 11") aufweist.

9. Vorrichtung nach einem der Ansprüche 6 bis 8 zum elektrischen Verbinden von Solarzellen (2, 2', 2") mit jeweils nebeneinander angeordneten Reihen von Kontaktstellen, **dadurch gekennzeichnet, dass** die Vorrichtung (1) je Kontaktstellen-Reihe jeweils eine Applizier-Einheit (3) aufweist, wobei die Applizier-Einheiten (4) in einer Reihe nebeneinander oder in Bezug auf die Längsrichtung versetzt zueinander angeordnet sind.

10. Vorrichtung nach einem der Ansprüche 6 bis 9, **dadurch gekennzeichnet, dass** die Vorrichtung (1) wenigstens eine Vorratsrolle (18, 18', 18") zum Bevorraten von Material (20) zum Herstellen der Leiter aufweist, von der mittels einer Abzieh-Einheit (7) Leitermaterial abziehbar ist.

11. Vorrichtung nach Anspruch 10, **dadurch gekennzeichnet, dass** die Abzieh-Einheit (7) wenigstens einen Greifer (19) zum klemmenden Ergreifen des freien Endes des Leitermaterials (20) von der Vorratsrolle (18, 18', 18 ") aufweist.

12. Vorrichtung zum elektrischen Verbinden von Solarzellen (2, 2', 2") insbesondere nach einem der Ansprüche 6 bis 9, **dadurch gekennzeichnet, dass** die Vorrichtung (1) eine Umformeinheit (8) zum Schaffen von Zugentlastungsstrukturen (26) für die Leiterelemente (12) aufweist.

13. Vorrichtung nach Anspruch 12, **dadurch gekennzeichnet, dass** die Umformeinheit (8) eine Biegegesenk (17) und einen Biegestempel (16) enthält, wobei wenigstens die Biegegesenk (17) und vorzugsweise auch der Biegestempel (16) zweiteilig ausgebildet ist oder sind und dass die beiden Biegegesenkteile (21, 22) und gegebenenfalls die Stempelteile (23, 24) zum Einstellen der Länge der Leiterelemente in Längsrichtung relativ zueinander verschiebbar sind.

14. Vorrichtung nach Anspruch 12 oder 13, **dadurch gekennzeichnet, dass** die Umformeinheit (8) eine Biegegesenk (17) und einen Biegestempel (18) enthält, wobei die Biegegesenk (17) und der Biegestempel (18) jeweils zweiteilig ausgebildet sind und dass die Biegegesenknteile (21, 22) und die zugehörigen Stempelteile (23, 24) paarweise zum Bilden einer Verformung (25) in Querrichtung (y) rechtwinklig zur Längsrichtung relativ zueinander verschiebbar sind.

15. Vorrichtung nach einem der Ansprüche 12 bis 14, **dadurch gekennzeichnet, dass** die Umformeinheit (8) Bestandteil einer Stanz-Station (40) ist, mit der neben dem Umformvorgang die Leiterelemente (12) ablängbar sind.

16. Vorrichtung nach einem der Ansprüche 12 bis 15, **dadurch gekennzeichnet, dass** die Vorrichtung (1) eine Fördereinrichtung (9) zum Fördern der hintereinander angeordneten Solarzellen (2, 2', 2") in Längsrichtung (x) aufweist, wobei die Applizier-Einheit (4) derart über oder unter der Fördereinrichtung (9) angeordnet ist, dass das wenigstens eine Isolationsband (11, 11', 11") beim Fördervorgang auf die Solarzellen (2, 2', 2") aufgebracht wird.

17. Vorrichtung nach Anspruch 16, **dadurch gekennzeichnet, dass** die Umformeinheit (8) und gegebenenfalls die Stanz-Station (40) in Bezug auf die Längsrichtung neben der Fördereinrichtung (9) angeordnet ist und dass die Leiterelemente (12) mittels einem vorzugsweise nach einem Pick and Place-Verfahren arbeitenden Bestückungs-Einheit (5) von der Stanz-Station (40) entnommen und auf das wenigstens eine Isolationsband (11, 11', 11") abgelegt werden.

18. Solarzellen-String insbesondere hergestellt nach dem Verfahren gemäss einem der Ansprüche 1 bis 5, mit hintereinander entlang einer Längsrichtung (L) angeordneten Solarzellen (2, 2', 2"), insbesondere Rückseiten-Solarzellen, wenigstens einem auf den Solarzellen (2, 2', 2") angeordneten, sich in Längsrichtung erstreckenden Isolationsband (11, 11', 11") und wenigstens einem auf dem Isolationsband befestigten, sich in Längsrichtung (x) erstreckende elektrischen Leiter (12), die jeweils zwei benachbarte Solarzellen (2, 2', 2") elektrisch miteinander verbinden.

19. Solarzellen-String nach Anspruch 18, **dadurch gekennzeichnet, dass** die Leiter jeweils streifenförmige Leiterelemente (12) sind, die zum Schaffen von Zugentlastungsstrukturen (26) als Biegeteile aus Metall ausgebildet sind, und dass die Leiterelemente (12) jeweils wenigstens einen flächig auf dem Isolationsband (11, 11', 11") aufliegenden Befestigungsabschnitt (27) aufweisen.
